# EUROPÄISCHE PATENTSCHRIFT

(11) **EP 2 150 488 B1**
(45) Veröffentlichungstag und Bekanntmachung des Hinweises auf die Patenterteilung: **12.06.2019**
(21) Anmeldenummer: 08735918.8
(22) Anmeldetag: 08.04.2008
(51) Int. Cl.: B81C 1/00

(54) **VERFAHREN ZUR HERSTELLUNG EINES MIKROMECHANISCHEN BAUELEMENTS MIT AUFFÜLLSCHICHT UND MASKENSCHICHT**
METHOD FOR PRODUCING A MICROMECHANICAL COMPONENT HAVING A FILLER LAYER AND A MASKING LAYER
PROCÉDÉ DE FABRICATION D'UN COMPOSANT MICROMÉCANIQUE COMPORTANT UNE COUCHE DE CHARGE ET UNE COUCHE DE MASQUE

(30) Priorität: 26.04.2007 DE 102007019647
(43) Veröffentlichungstag der Anmeldung: 10.02.2010
(73) Patentinhaber: Robert Bosch GmbH, 70442 Stuttgart (DE)
(72) Erfinder: SCHEUERER, Roland, 72768 Reutlingen (DE); WEBER, Heribert, 72622 Nuertingen (DE); GRAF, Eckhard, 72810 Gomaringen (DE)
(86) Internationale Anmeldenummer: PCT/EP2008/054187
(87) Internationale Veröffentlichungsnummer: WO 2008/132024

(56) Entgegenhaltungen:
- DE-A1-102004 037 304
- US-A1- 2005 098 840

## Beschreibung

### Stand der Technik

Die Erfindung geht aus von einem Verfahren nach der Gattung des Hauptanspruchs. Die US 2005/0098840 A1 offenbart ein mikromechanisches Strukturelement mit einer sehr stabilen Membran, ausgeführt in einem reinen Front-Prozess und in einem Schichtaufbau auf einem Substrat. Der Schichtaufbau umfasst eine Opferschicht und oberhalb der Opferschicht eine Membranschicht. Die DE 10 2004 037304 A1 offenbart einen mikrostrukturierten Sensor, der mindestens ein Substrat, eine in das Substrat geätzte Kaverne, eine Membran, die oberhalb der Kaverne freitragend ausgebildet und in einer Membrankante lateral angebunden ist, und eine Sensorschicht mit Sensorstrukturen aufweist. Aus der deutschen Offenlegungsschrift DE 2004 036 035 A1 sind mikromechanische Bauelemente mit Trenchstrukturen allgemein bekannt. Nachteilig bei den bekannten mikromechanischen Bauelementen ist jedoch, dass insbesondere große Trenchstrukturen in der Regel nicht vollständig verfüllt werden können und zudem bei einem mikromechanischen Bauelement mit beweglichen Sensorstrukturen Kappenwafer aufwändig strukturiert werden müssen, damit die Kappenwafer im Abstand zu den beweglichen Sensorstrukturen sind.

### Offenbarung der Erfindung

Das erfindungsgemäße Verfahren gemäß dem Hauptanspruch beziehungsweise den Merkmalen der nebengeordneten Ansprüche hat demgegenüber den Vorteil, dass in unkomplizierter Weise auch große Trenchstrukturen durch eine erste Auffüllschicht im wesentlichen vollständig verfüllt werden können und gleichzeitig Auffüllschichten als Funktionsschicht verwendet werden können. Durch die Funktionsschicht können dabei Abstandselemente zum Schutz der beweglichen Sensorstrukturen gegen den Kontakt mit einem Kappenwafer gebildet werden. Zur Bildung der Abstandselemente wird bei dem Verfahren zur Herstellung des mikromechanischen Bauelements über die erste Auffüllschicht mit der ersten Maskenschicht eine zweite Auffüllschicht aufgebracht und darüber eine zweite Maskenschicht aufgetragen. Die erste Maskenschicht wird somit "vergraben" unter der zweiten Auffüllschicht, wodurch in vorteilhafter Weise bei einem Ätzvorgang die erste Maskenschicht als Stoppschicht wirkt, wodurch das unter der ersten

Erfindungsgemäß werden bei einem (nächsten) Ätzschritt ein Abstandselement und eine Sensorstruktur gebildet. Bevorzugt werden dabei weitere Trenchstrukturen gebildet. Die Sensorstruktur ist dabei jedoch lediglich eine Vorstufe zu einer freibeweglichen Sensorstruktur. Demnach kann aus der Sensorstruktur eine bewegliche Sensorstruktur gebildet werden. Das Abstandselement umfasst bevorzugt sowohl die erste als auch die zweite Auffüllschicht und weist eine Höhe auf, die vorzugsweise größer ist als die Höhe der (vorläufigen) Sensorstruktur und der später gebildeten beweglichen Sensorstruktur.

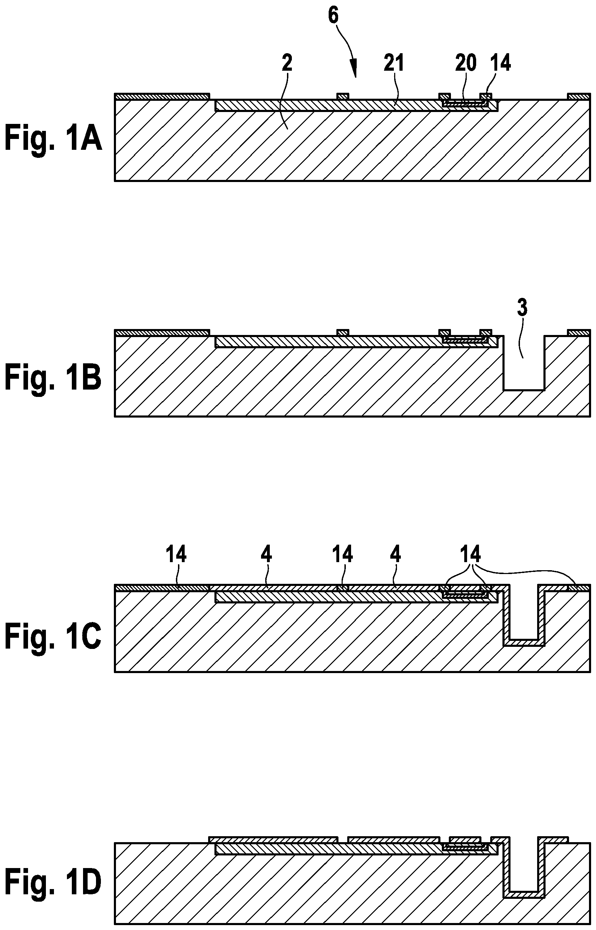

Vorzugsweise werden zumindest einige der Sensorstrukturen durch einen weiteren Ätzschritt zu beweglichen Sensorstrukturen, wobei hierzu bevorzugt eine vorher aufgetragene erste Isolationsschicht entfernt wird (siehe Fig. 1A bis Fig. 1I). Als erste Isolationsschicht wird bevorzugt eine Oxidschicht verwendet, wobei die Oxidschicht beispielsweise durch einen Gasphasenätzschritt entfernt werden kann. Vorzugsweise werden die beweglichen Sensorstrukturen aus der ersten Auffüllschicht gebildet.

Im Gegensatz zur Sensorstruktur und zur beweglichen Sensorstruktur weist das Abstandselement bevorzugt sowohl die erste als auch die zweite Auffüllschicht auf. Ist eine oder beide der Auffüllschichten monokristalline oder polykristallin, so weist auch das Abstandselement einen monokristallinen und/oder polykristallinen Aufbau auf. Die Sensorstruktur und die bewegliche Sensorstruktur weisen bevorzugt nur die erste Auffüllschicht auf und sind vorzugsweise entweder monokristallin oder polykristallin aufgebaut. Wie im vorhergehenden Abschnitt erwähnt wird die Sensorstruktur beispielsweise durch einen weiteren Ätzschritt zu einer beweglichen Sensorstruktur, weshalb auch der Begriff vorläufige Sensorstruktur verwendet werden kann.

Bevorzugt wird ein Kappenwafer, beispielsweise durch anodisches Bonden oder Sealglasbonden mit dem Abstandselement und/oder mit monokristallinen oder polykristallinen Bereichen der Auffüllschichten verbunden. Bevorzugt ist jedoch auch, wenn der Kappenwafer mit mindestens einer (vorläufigen, nicht beweglichen) Sensorstruktur und/oder monokristallinen beziehungsweise polykristallinen Bereichen der Auffüllschichten verbunden wird. Wenn das mikromechanische Bauelement kein Abstandselement aufweist sind somit die Sensorstrukturen in vorteilhafter Weise nicht nur als Vorstufe zu den beweglichen Sensorstrukturen gedacht, sondern dienen zusätzlich der Reduzierung der Kappendurchbiegung im Bereich der beweglichen Sensorstrukturen. Bei einem mikromechanischen Bauelement ohne Abstandselement ist bei der Verbindung zwischen einem nicht strukturiertem Kappenwafer und der Sensorstruktur darauf zu achten, dass die beweglichen Sensorstrukturen nicht durch den unstrukturierten Kappenwafer blockiert werden. Dies lässt sich durch die Verwendung einer Verbindungsschicht, wie beispielsweise dem Sealglas, sicherstellen. Über die Dicke der Sealglasschicht kann zuverlässig der nötige Abstand zu den beweglichen Sensorstrukturen sichergestellt werden. Es soll hierbei noch einmal klargestellt werden, dass es sich bei der Sensorstruktur zur Verbindung mit dem Kappenwafer nicht um eine bewegliche Sensorstruktur handelt, sondern um eine (vorläufige) Sensorstruktur, die nicht durch einen weiteren Ätzschritt zu einer beweglichen Sensorstruktur geworden ist. Unter einem Kappenwafer sollen alle Bauteile verstanden werden, die zum Verschließen von zumindest Teilbereichen eines mikromechanischen Bauelements verwendetet werden können. Durch das Abstandselement beziehungsweise die Sensorstruktur mit beispielsweise sealglasgebondeten Kappewafer ist es vorteilhaft möglich, auch unstrukturierte Kappenwafer zu verwenden, so dass eine aufwändige Strukturierung der Kappenwafer wegfällt. Insbesondere bei der Verwendung eines Abstandselements ist keine aufwändige Strukturierung von beispielsweise Pyrex-Kappenwafern vor dem anodischen Bonden mehr notwendig. Selbstverständlich können jedoch auch strukturierte Kappenwafer oder auch nur in Teilbereichen strukturierte Kappenwafer verwendet werden, wobei durch die Strukturierung des Kappenwafers beispielsweise eine elektrische Kontaktierung des mikromechanischen Bauelements möglich wird.

Bevorzugt wird der Kappenwafer und/oder eine zweite Seite des Substratmaterials planarisiert. Bei einer Planarisierung der zweiten Seite des Substratmaterials erfolgt vorteilhaft eine Planarisierung bis in eine Ebene der Trenchstruktur. Durch die Planarisierung des Kappenwafers und/oder der zweiten Seite des Substratmaterials wird vorteilhaft das mikromechanische Bauelement dünner. Zudem wird durch eine Planarisierung der zweiten Seite des Substratmaterials bis in eine Ebene der Trenchstruktur vorteilhaft eine Rückseitenkontaktierung des mikromechanischen Bauelements möglich.

Ein weiterer Gegenstand der vorliegenden Erfindung ist ein mikromechanisches Bauelement, hergestellt nach dem beschriebenen Verfahren. Bei dem mikromechanischen Bauelement ist die Trenchstruktur, die zur Durchkontaktierung des mikromechanischen Bauelements benötigt wird, im wesentlichen vollständig von der ersten Auffüllschicht aufgefüllt, wobei die erste Auffüllschicht auch zur Realisierung der beweglichen Sensorstrukturen dient. In vorteilhafter Weise kann bei der Verwendung einer leitfähigen ersten Auffüllschicht die erste Auffüllschicht zum einem eine Voraussetzung zur Rückseitenkontaktierung schaffen und zum anderen die beweglichen Sensorstrukturen bilden.

Bevorzugt ist der Kappenwafer durch eine anodische Bondung oder eine Sealglasbondung mit dem Abstandselement und/oder den monokristallinen beziehungsweise den polykristallinen Bereichen der Auffüllschichten verbunden. Das Abstandselement wird dabei durch die erste und die zweite Auffüllschicht gebildet und weist eine größere Höhe auf, als die bewegliche Sensorstruktur oder die Sensorstruktur. Durch die größere Höhe gegenüber der beweglichen Sensorstruktur kann der Kappenwafer vorteilhaft direkt durch eine anodische Bondung mit dem Abstandselement verbunden werden, ohne dass eine Strukturierung des Kappenwafers vorgenommen werden muss oder die beweglichen Sensorstrukturen durch den Kontakt mit dem Kappenwafer behindert würden. Durch das Abstandselement ist es somit vorteilhaft möglich eine anodische Bondung zwischen Kappenwafer und mikromechanischen Bauelement durchzuführen, ohne dass der Kappenwafer strukturiert wird.

Vorzugsweise wird der Kappenwafer durch eine Sealglasbondung mit den Sensorstrukturen und/oder den monokristallinen Bereichen, welche optional auch polykristallin ausgeführt sein können, verbunden. Auch hierbei muss der Kappenwafer vorteilhaft nicht strukturiert werden, da das Sealglas für einen Abstand zwischen dem Kappenwafer und den beweglichen Sensorstrukturen sorgt.

Vorzugsweise weist das mikromechanische Bauelement eine erste Isolationsschicht und/oder eine dritte Isolationsschicht auf. Die erste Isolationsschicht wird vorzugsweise auf der ersten Seite des Substratmaterials abgeschieden und bedeckt dabei bevorzugt mindestens die Wände und den Boden der Trenchstruktur. Die dritte Isolationsschicht wird, nach dem die zweite Seite des Substratmaterials bis in eine Ebene der Trenchstruktur planarisiert wurde, bevorzugt auf der zweiten Seite des Substratmaterials abgeschieden. Die erste Isolationsschicht entsteht bevorzugt durch ein LOCOS-Verfahren. Die dritte Isolationsschicht dagegen wird bevorzugt durch ein CVD-Abscheideverfahren erzeugt.

Bevorzugt ist das mikromechanische Bauelement von einer ersten Seite des Substratmaterials und/oder von einer zweiten Seite des Substratmaterials ausgehend planarisiert. Durch die Planarisierung wird das mikromechanische Bauelement vorteilhaft dünner und kann so besser auch in flache Baugruppen eingebaut werden.

Vorzugsweise ist das mikromechanische Bauelement von der zweiten Seite des Substratmaterials ausgehend bis in eine Ebene der Trenchstruktur planarisiert. Hierdurch wird Vorteilhaft die Rückseitenkontaktierung des mikromechanischen Bauelements möglich, wenn als erste Auffüllschicht ein leitendes Material verwendet wird.

Vorzugsweise ist der mit dem mikromechanischem Bauelement in Kontakt stehende Kappenwafer ein Pyrex-Wafer oder ein Siliziumwafer oder ein Verbund aus einem Pyrex- und einem Siliziumwafer.

### Kurze Beschreibung der Zeichnungen

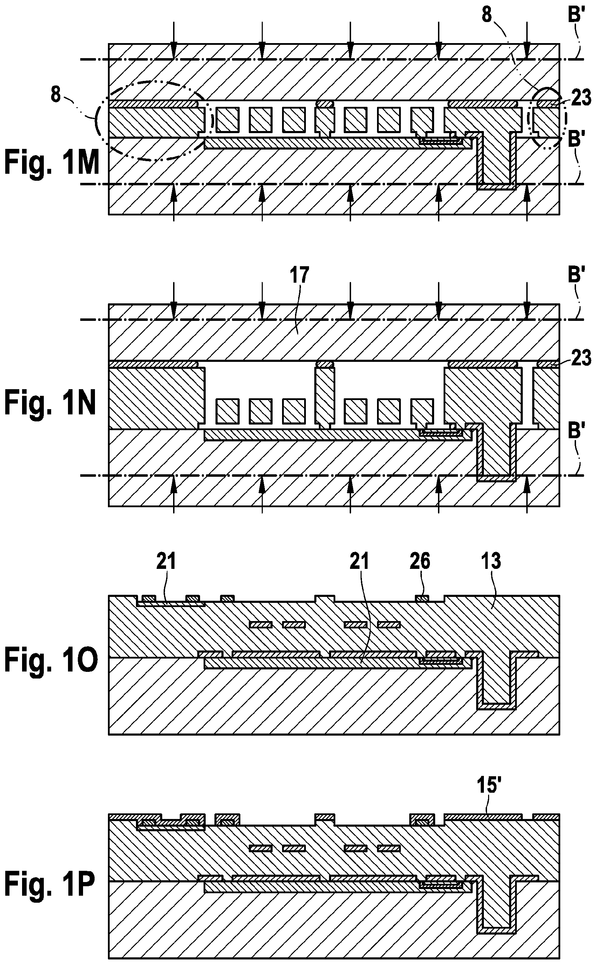

Ausführungsbeispiele der Erfindung sind in den Zeichnungen 1 A bis 1 L und 1 N bis 1T dargestellt und in der nachfolgenden Beschreibung näher erläutert. Die Figur 1 M stellt eine nicht erfindungsgemässe Alternative zur Erfindung dar.

Die Figuren 1 A bis 1 T stellen schematisch ein Verfahren zur Herstellung eines mikromechanischen Bauelements dar.

### Ausführungsform(en) der Erfindung

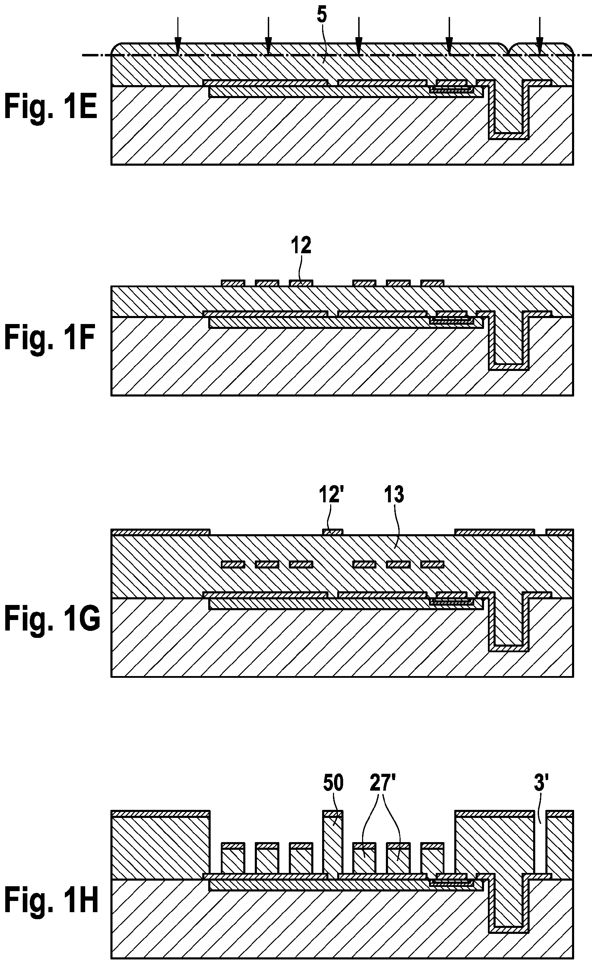

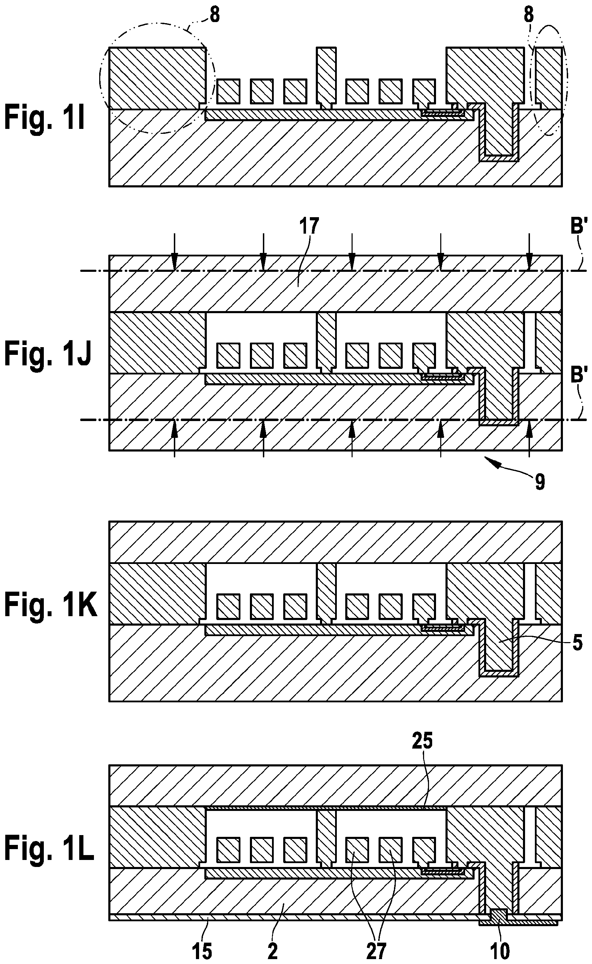

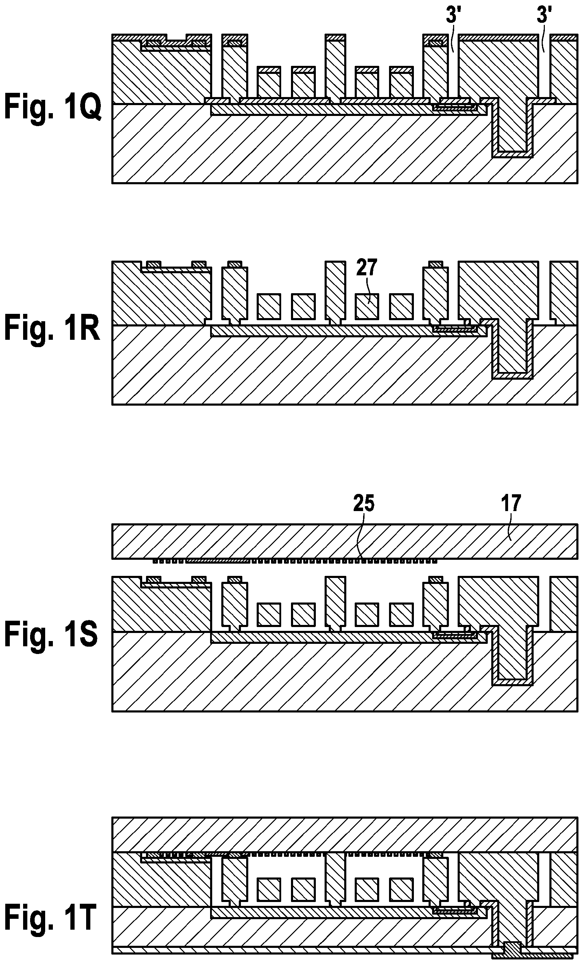

In der Figur 1 A ist schematisch ein Substratmaterial 2, beispielsweise Silizium, mit einem Schaltungsbereich 21 und mit einer Leiterbahn 20 dargestellt. Auf einer ersten Seite 6 des Substratmaterials 2 wird eine dritte Maskenschicht 14, beispielsweise aus Siliziumnitrid, aufgetragen. In der Figur 1 B ist schematisch dargestellt, wie eine Trenchstruktur 3 im Substratmaterial 2 erzeugt wurde. Durch ein anschließendes, beispielsweise LOCOS-Verfahren, wird eine erste Isolationsschicht 4 auf dem Substratmaterial 2 abgeschieden, wobei die Wände und der Boden der Trenchstruktur 3 von der ersten Isolationsschicht 4 bedeckt werden (Figur 1 C). Die Bereiche, in welche die dritte Maskenschicht 14 aufgetragen wurde, bleiben jedoch frei von der dritten Isolationsschicht 4. Nach dem Entfernen der dritten Maskenschicht 14, beispielsweise durch ein Ätzschritt, entstehen Lücken in der ersten Isolationsschicht 4 (Figur 1 D). Sowohl diese Lücken als auch die erste Trenchstruktur 3 werden von einer ersten Auffüllschicht 5, die beispielsweise aus dotiertem Silizium besteht, aufgefüllt (Figur 1 E), wobei die erste Auffüllschicht 5 in den Lücken der Isolationsschicht 4 monokristallin aufwachsen kann. Die erste Auffüllschicht 5 wird dann bevorzugt planarisiert, wie die gestrichelte Linie in der Figur 1 E andeutet. Nach dem Planarisieren wird bevorzugt eine erste Maskenschicht 12, bestehend beispielsweise aus Siliziumoxid, auf der so im wesentlichen planen Oberfläche der ersten Auffüllschicht 5 aufgetragen (Figur 1 F). In der Figur 1 G ist schematisch dargestellt, wie eine zweite Auffüllschicht 13, beispielsweise ebenfalls bestehend aus dotiertem Silizum, über die erste Maskenschicht 12 und die erste Auffüllschicht 5 aufgebracht wird. Anschließend wird eine zweite Maskenschicht 12', beispielsweise Siliziumoxid oder Fotolack, auf der zweiten Auffüllschicht 13 aufgetragen. Bevorzugt wird die zweite Auffüllschicht 13 vor dem Aufbringen der zweiten Maskenschicht 12' planarisiert. Die erste Maskenschicht 12 ist somit unter der zweiten Auffüllschicht 13 vergraben. Nach einem Ätzschritt entsteht durch die vergrabene erste Maskenschicht 12 und die zweite Maskenschicht 12' bevorzugt sowohl eine Sensorstruktur 27' als auch ein Abstandselement 50 (Figur 1 H). Das Abstandselement 50 wird dabei bevorzugt aus der ersten und der zweiten Auffüllschicht 5, 13 gebildet und weist eine Höhe auf, die größer ist als die Höhe der Sensorstruktur 27'. Bevorzugt werden bei dem eben genannten Ätzschritt auch weitere Trenchstrukturen 3' gebildet. Durch einen weiteren Ätzschritt werden anschließend bevorzugt Teilbereiche der ersten Isolationsschicht 4 entfernt, wobei die erste Isolationsschicht 4 im Bereich der Trenchstruktur 3 durch die erste und die zweite Auffüllschicht 5, 13 geschützt ist und nicht entfernt wird. Durch die Entfernung der ersten Isolationsschicht 4 entstehen zumindest aus einigen Sensorstrukturen 27' bewegliche Sensorstrukturen 27, wie die Figur 1 I darstellt. Durch das Aufbringen von der ersten Auffüllschicht 5 und der zweiten Auffüllschicht 13 direkt auf das Substratmaterial 2 können zudem vorteilhaft Bereiche 8 aus beispielsweise monokristallinem Silizium gebildet werden, wenn die erste Auffüllschicht 5 und die zweite Auffüllschicht 13 durch Abscheiden von EPI-Polysilizium aufgebaut werden. Nach dem zweiten Planarisierungsschritt besitzen die Bereiche 8 bevorzugt dann die gleiche Höhe, wie ein Abstandselement 50. Selbstverständlich können die Bereiche 8 auch aus polykristallinem Silizium bestehen. In der Figur 1 J wird ein Kappenwafer 17 mit dem Abstandselement 50 durch anodisches Bonden verbunden dargestellt. Die beweglichen Sensorstrukturen 27 kommen dabei selbst bei einem unstrukturierten Kappenwafer 17 nicht mit dem Kappenwafer 17 in Kontakt, da das Abstandselement 50 und die Bereiche 8 eine Höhe aufweisen, die größer ist als die Höhe der beweglichen Sensorstrukturen 27. Im Ausführungsbeispiel liegt der Kappenwafer 17 sowohl auf dem Abstandselement 50 als auch auf den Bereichen 8 auf. Bevorzugt wird der Kappenwafer 17, ausgehend von der ersten Seite 6 des Substratmaterials 2, und das Substratmaterial 2, ausgehend von einer zweiten Seite 9 des Substratmaterials 2, planarisiert. Die Ebenen, bis zu denen planarisiert werden soll, sind dabei mit B' angegeben, wobei die Ebene B' der zweiten Seite 9 des Substratmaterials 2 bis in eine Ebene der Trenchstruktur 3 reicht. Hierdurch wird vorteilhaft eine Rückseitenkontaktierung des fertigen mikromechanischen Bauelements 1 möglich. In der Figur 1 K ist schematisch eine Ausführungsform des mikromechanischen Bauelements 1 dargestellt. Die Figur 1 L stellt schematisch eine andere Ausführungsform des mikromechanischen Bauelements 1 dar, wobei der Kappenwafer 17 eine Zusatzschicht 25 aufweist und eine dritte Isolationsschicht 15 auf der zweiten Seite 9 des Substratmaterials 2 erzeugt wurde. Die Zusatzschicht 25 kann beispielweise ein Isolator, aber auch eine elektrisch leitfähig Schicht sein, welche optional elektrisch kontaktiert sein kann. Eine zusätzliche Schicht 10 befindet sich in Kontakt mit der ersten Auffüllschicht 5 in der Trenchstruktur 3. Bevorzugt handelt es sich bei der zusätzlichen Schicht 10 um eine Aluminium-Metallisierung. Denkbar ist auch eine Metallisierung, die eine Flip-Chip Verbindung zu anderen Bauteilen ermöglicht. Die nicht erfindungsgemässe Alternative in der Figur 1M stellt zur Erleichterung des Verständnisses der vorliegenden Erfindung schematisch ein zu fertigendes mikromechanisches Bauelement 1 ohne Abstandselement 50 dar. In diesem Fall ist der Kappenwafer 17 durch eine Verbindungsschicht 23 mit der Sensorstruktur 27' und den Bereichen 8 verbunden, wobei die Verbindungsschicht 23 beispielsweise aus Sealglas bestehen kann. Auch in diesem Fall kommen die beweglichen Sensorstrukturen 27 nicht mit dem nicht strukturierten Kappenwafer 17 in Kontakt. In der Figur 1N ist eine Ausführungsform eines mikromechanischen Bauelements 1 mit Abstandselement 50 und Verbindungsschicht 23 dargestellt. In den Figuren 1O bis 1T wird eine Ausführungsform mit Kontaktpads 26 dargestellt, wobei die Kontaktpads 26 auf der zweiten Auffüllschicht 13 aufgetragen und von einer zweiten Isolationsschicht 15 überdeckt werden. In Verbindung mit der Zusatzschicht 25 entsteht ein Kontakt zu dem Kappenwafer 17. In einer anderen Alternative (nicht dargestellt) ist prinzipiell keine Rückseitenkontaktierung des beschriebenen mikromechanischen Bauelements 1 notwendig. Es ist ebenso denkbar, dass der Kappenwafer 17 beispielsweise im Bereich von Bondpads strukturiert ist, um eine elektrische Kontaktierung des mikromechanischen Bauelements 1 von der ersten Seite 6 aus zu ermöglichen. Im Bereich der beweglichen Sensorstrukturen 27 muss der Kappenwafer 17 jedoch in diesem Fall nicht strukturiert werden, da die Verbindungsschicht 23 (beispielsweise Sealglas) für einen Abstand zwischen Kappenwafer 17 und beweglichen Sensorstrukturen 27 sorgt. Die eben genannte teilweise Strukturierung des Kappenwafers 17 kann sowohl bei Kappenwafern, die auf nicht beweglichen Sensorstrukturen 27 befestigten werden als auch bei Kappenwafer, die auf Abstandselementen 50 befestigten werden, umgesetzt werden.

## Patentansprüche

1. Verfahren zur Herstellung eines mikromechanischen Bauelements (1), wobei in einem Substratmaterial (2) ausgehend von einer ersten Seite (6) eine Trenchstruktur (3) erzeugt wird, wobei die Trenchstruktur (3) von einer ersten Auffüllschicht (5) im wesentlichen vollständig aufgefüllt wird, **dadurch gekennzeichnet, dass** eine erste Maskenschicht (12) auf die erste Auffüllschicht (5) aufgebracht wird und dass über die erste Maskenschicht (12) eine zweite Auffüllschicht (13) aufgebracht wird und darüber eine zweite Maskenschicht (12') aufgebracht wird, und dass bei einem Ätzschritt durch die vergrabene erste Maskenschicht (12) und die zweite Maskenschicht (12') eine Sensorstruktur (27') und ein Abstandselement (50) gebildet werden.

2. Verfahren zur Herstellung des mikromechanischen Bauelements (1) nach Anspruch 1, **dadurch gekennzeichnet, dass** vor der ersten Auffüllschicht (5) eine dritte Maskenschicht (14) und eine erste Isolationsschicht (4) auf dem Substratmaterial (2) aufgetragen werden.

3. Verfahren zur Herstellung des mikromechanischen Bauelements (1) nach einem der vorhergehenden Ansprüche, **dadurch gekennzeichnet, dass** die erste Auffüllschicht (5) und/oder die zweite Auffüllschicht (13) im wesentlichen vollständig die erste Seite (6) des Substratmaterials (2) bedeckend aufgebracht werden.

4. Verfahren zur Herstellung des mikromechanischen Bauelements (1) nach einem der vorhergehenden Ansprüche, **dadurch gekennzeichnet, dass** ausgehend von der ersten Seite (6) des Substratmaterials (2) die erste Auffüllschicht (5) vor dem Auftragen der ersten Maskenschicht (12) planarisiert wird.

5. Verfahren zur Herstellung des mikromechanischen Bauelements (1) nach einem der vorhergehenden Ansprüche, **dadurch gekennzeichnet, dass** ausgehend von der ersten Seite (6) des Substratmaterials (2) die zweite Auffüllschicht (13) vor dem Auftragen der zweiten Maskenschicht (12') planarisiert wird.

6. Verfahren zur Herstellung des mikromechanischen Bauelements (1) nach einem der vorhergehenden Ansprüche, **dadurch gekennzeichnet, dass** bei dem einem Ätzschritt weitere Trenchstrukturen (3') gebildet werden.

7. Verfahren zur Herstellung des mikromechanischen Bauelements (1) nach einem der vorhergehenden Ansprüche, **dadurch gekennzeichnet, dass** durch einen weiteren Ätzschritt aus den Sensorstrukturen (27') zumindest teilweise bewegliche Sensorstrukturen (27) gebildet werden, wobei die beweglichen Sensorstrukturen (27) im mikromechanischen Bauelement (1) aus der ersten Auffüllschicht (5) gebildet werden.

8. Verfahren zur Herstellung des mikromechanischen Bauelements (1) nach einem der vorhergehenden Ansprüche, **dadurch gekennzeichnet, dass** ein Kappenwafer (17) durch anodisches Bonden oder Sealglasbonden mit dem Abstandselement (50) und/oder monokristallinen oder polykristallinen Bereichen (8) verbunden wird oder ein Kappenwafer (17) durch Sealglasbondung mit der Sensorstruktur (27') und/oder den monokristallinen oder polykristallinen Bereichen (8) verbunden wird.

9. Verfahren zur Herstellung des mikromechanischen Bauelements (1) nach einem der vorhergehenden Ansprüche, **dadurch gekennzeichnet, dass** der Kappenwafer (17) und/oder eine zweite Seite (9) des Substratmaterials (2) planarisiert werden, wobei die Planarisierung der zweiten Seite (9) des Substratmaterials (2) bis in eine Ebene der Trenchstruktur (3) erfolgt.

10. Mikromechanisches Bauelement (1) hergestellt nach einem Verfahren gemäß den Ansprüchen 1 bis 9, **dadurch gekennzeichnet, dass** die Trenchstruktur (3) von der ersten Auffüllschicht (5) im wesentlichen vollständig aufgefüllt ist, wobei die erste Auffüllschicht (5) die beweglichen Sensorstrukturen (27) und die Sensorstruktur (27') ausbildet.

11. Mikromechanisches Bauelement (1) nach Anspruch 10, **dadurch gekennzeichnet, dass** ein Kappenwafer (17) durch anodische Bondung oder Sealglasbondung mit dem Abstandselement (50) und/oder den monokristallinen oder polykristallinen Bereichen (8) verbunden ist.

12. Mikromechanisches Bauelement (1) nach Anspruch 10, **dadurch gekennzeichnet, dass** ein Kappenwafer (17) mit den Sensorstrukturen (27') und/oder den monokristallinen oder polykristallinen Bereichen (8) durch eine Sealglasbondung verbunden ist.

13. Mikromechanisches Bauelement (1) nach einem der vorhergehenden Ansprüche, **dadurch gekennzeichnet, dass** das mikromechanische Bauelement (1) eine erste Isolationsschicht (4) und/oder eine dritte Isolationsschicht (15) aufweist.

14. Mikromechanisches Bauelement (1) nach einem der vorhergehenden Ansprüche, **dadurch gekennzeichnet, dass** das mikromechanische Bauelement (1) von einer ersten Seite (6) des Substratmaterials (2) und/oder von einer zweiten Seite (9) des Substratmaterials (2) ausgehend planarisiert ist.

15. Mikromechanisches Bauelement (1) nach einem der vorhergehenden Ansprüche, **dadurch gekennzeichnet, dass** das mikromechanische Bauelement (1) von der zweiten Seite (9) des Substratmaterials (2) bis in eine Ebene der Trenchstruktur (3) planarisiert ist.

16. Mikromechanisches Bauelement (1) nach Anspruch 11 oder 12, **dadurch gekennzeichnet, dass** der Kappenwafer (17) ein Composite-Verbund aus einem Pyrex- und einem Siliziumwafer umfasst.

17. Mikromechanisches Bauelement (1) nach Anspruch 11 oder 12, **dadurch gekennzeichnet, dass** der Kappenwafer (17) aus einem Pyrex-Wafer besteht.

18. Mikromechanisches Bauelement (1) nach Anspruch 11 oder 12, **dadurch gekennzeichnet, dass** der Kappenwafer (17) aus einem Silizumwafer besteht.

## Claims

1. Method for producing a micromechanical component (1), wherein a trench structure (3) is produced in a substrate material (2) proceeding from a first side (6), wherein the trench structure (3) is substantially completely filled by a first filling layer (5), **characterized in that** a first mask layer (12) is applied on the first filling layer (5), and **in that** a second filling layer (13) is applied over the first mask layer (12) and a second mask layer (12') is applied over said second filling layer, and **in that** a sensor structure (27') and a spacer element (50) are formed during an etching step through the buried first mask layer (12) and the second mask layer (12').

2. Method for producing the micromechanical component (1) according to Claim 1, **characterized in that** before the first filling layer (5), a third mask layer (14) and a first insulation layer (4) are applied on the substrate material (2).

3. Method for producing the micromechanical component (1) according to either of the preceding claims, **characterized in that** the first filling layer (5) and/or the second filling layer (13) are/is applied in a manner substantially completely covering the first side (6) of the substrate material (2).

4. Method for producing the micromechanical component (1) according to any of the preceding claims, **characterized in that** proceeding from the first side (6) of the substrate material (2), the first filling layer (5) is planarized before the first mask layer (12) is applied.

5. Method for producing the micromechanical component (1) according to any of the preceding claims, **characterized in that** proceeding from the first side (6) of the substrate material (2), the second filling layer (13) is planarized before the second mask layer (12') is applied.

6. Method for producing the micromechanical component (1) according to any of the preceding claims, **characterized in that** further trench structures (3') are formed during said etching step.

7. Method for producing the micromechanical component (1) according to any of the preceding claims, **characterized in that** at least partly movable sensor structures (27) are formed from the sensor structures (27') by means of a further etching step, wherein the movable sensor structures (27) are formed from the first filling layer (5) in the micromechanical component (1).

8. Method for producing the micromechanical component (1) according to any of the preceding claims, **characterized in that** a cap wafer (17) is connected to the spacer element (50) and/or monocrystalline or polycrystalline regions (8) by anodic bonding or seal glass bonding, or a cap wafer (17) is connected to the sensor structure (27') and/or the monocrystalline or polycrystalline regions (8) by seal glass bonding.

9. Method for producing the micromechanical component (1) according to any of the preceding claims, **characterized in that** the cap wafer (17) and/or a second side (9) of the substrate material (2) are/is planarized, wherein the planarization of the second side (9) of the substrate material (2) is carried out right into a plane of the trench structure (3).

10. Micromechanical component (1) produced according to a method according to Claims 1 to 9, **characterized in that** the trench structure (3) is substantially completely filled by the first filling layer (5), wherein the first filling layer (5) forms the movable sensor structures (27) and the sensor structure (27').

11. Micromechanical component (1) according to Claim 10, **characterized in that** a cap wafer (17) is connected to the spacer element (50) and/or the monocrystalline or polycrystalline regions (8) by anodic bonding or seal glass bonding.

12. Micromechanical component (1) according to Claim 10, **characterized in that** a cap wafer (17) is connected to the sensor structures (27') and/or the monocrystalline or polycrystalline regions (8) by seal glass bonding.

13. Micromechanical component (1) according to any of the preceding claims, **characterized in that** the micromechanical component (1) has a first insulation layer (4) and/or a third insulation layer (15).

14. Micromechanical component (1) according to any of the preceding claims, **characterized in that** the micromechanical component (1) is planarized proceeding from a first side (6) of the substrate material (2) and/or from a second side (9) of the substrate material (2).

15. Micromechanical component (1) according to any of the preceding claims, **characterized in that** the micromechanical component (1) is planarized from the second side (9) of the substrate material (2) right into a plane of the trench structure (3).

16. Micromechanical component (1) according to Claim 11 or 12, **characterized in that** the cap wafer (17) comprises a composite assemblage composed of a Pyrex wafer and a silicon wafer.

17. Micromechanical component (1) according to Claim 11 or 12, **characterized in that** the cap wafer (17) consists of a Pyrex wafer.

18. Micromechanical component (1) according to Claim 11 or 12, **characterized in that** the cap wafer (17) consists of a silicon wafer.

## Revendications

1. Procédé de fabrication d'un composant micromécanique (1), une structure de tranchée (3) étant réalisée dans un matériau de substrat (2) depuis un premier côté (6), la structure en tranchée (3) étant sensiblement entièrement remplie par une première couche de remplissage (5), **caractérisée en ce qu'**une première couche de masque (12) est appliquée sur la première couche de remplissage (5) et **en ce qu'**une deuxième couche de remplissage (13) est appliquée pardessus la première couche de masque (12) et une deuxième couche de masque (12') est appliquée pardessus la deuxième couche de remplissage, et **en ce qu'**une structure de détection (27') et un élément d'espacement (50) sont formés lors d'une étape de gravure à travers la première couche de masque (12) enfouie et la deuxième couche de masque (12').

2. Procédé de fabrication du composant micromécanique (1) selon la revendication 1, **caractérisé en ce qu'**une troisième couche de masque (14) et une première couche d'isolation (4) sont appliquées sur le matériau de substrat (2) avant la première couche de remplissage (5) .

3. Procédé de fabrication du composant micromécanique (1) selon l'une des revendications précédentes, **caractérisé en ce que** la première couche de remplissage (5) et/ou la deuxième couche de remplissage (13) sont appliquées de manière à recouvrir sensiblement complètement le premier côté (6) du matériau de substrat (2).

4. Procédé de fabrication du composant micromécanique (1) selon l'une quelconque des revendications précédentes, **caractérisé en ce que** la première couche de remplissage (5) est planarisée depuis le premier côté (6) du matériau de substrat (2) avant l'application de la première couche de masque (12).

5. Procédé de fabrication du composant micromécanique (1) selon l'une quelconque des revendications précédentes, **caractérisé en ce que** la deuxième couche de remplissage (13) est planarisée depuis le premier côté (6) du matériau de substrat (2) avant l'application de la deuxième couche de masque (12').

6. Procédé de fabrication du composant micromécanique (1) selon l'une des revendications précédentes, **caractérisé en ce que** des structures de tranchée supplémentaires (3') sont formées lors de la première étape de gravure.

7. Procédé de fabrication du composant micromécanique (1) selon l'une des revendications précédentes, **caractérisé en ce que** des structures de détection (27) au moins partiellement mobiles sont formées à partir des structures de capteur (27') par une étape de gravure supplémentaire, les structures de détection mobiles (27) du composant micromécanique (1) sont formées à partir de la première couche de remplissage (5) .

8. Procédé de fabrication du composant micromécanique (1) selon l'une des revendications précédentes, **caractérisé en ce qu'**une plaquette formant coiffe (17) est liée à l'élément d'espacement (50) et/ou à des régions monocristallines ou polycristallines (8) par liaison anodique ou par liaison au verre de scellement ou une plaquette formant coiffe (17) est liée à la structure de détection (27') et/ou aux régions monocristallines ou polycristallines (8) par une liaison au verre de scellement.

9. Procédé de fabrication du composant micromécanique (1) selon l'une des revendications précédentes, **caractérisé en ce que** la plaquette formant coiffe (17) et/ou un deuxième côté (9) du matériau de substrat (2) sont planarisés, la planarisation du deuxième côté (9) du matériau de substrat (2) étant effectuée jusque dans un plan de la structure de tranchée (3).

10. Composant micromécanique (1) fabriqué par un procédé selon les revendications 1 à 9, **caractérisé en ce que** la structure de tranchée (3) est sensiblement entièrement remplie par la première couche de remplissage (5), la première couche de remplissage (5) formant les structures de détection mobiles (27) et la structure de détection (27').

11. Composant micromécanique (1) selon la revendication 10, **caractérisé en ce qu'**une plaquette formant coiffe (17) est liée à l'élément d'espacement (50) et/ou aux régions monocristallines ou polycristallines (8) par liaison anodique ou liaison au verre de scellement.

12. Composant micromécanique (1) selon la revendication 10, **caractérisé en ce qu'**une plaquette formant coiffe (17) est liée aux structures de détection (27') et/ou aux régions monocristallines ou polycristallines (8) par une liaison au verre de scellement.

13. Composant micromécanique (1) selon l'une des revendications précédentes, **caractérisé en ce que** le composant micromécanique (1) comporte une première couche d'isolation (4) et/ou une troisième couche d'isolation (15).

14. Composant micromécanique (1) selon l'une des revendications précédentes, **caractérisé en ce que** le composant micromécanique (1) est planarisé depuis un premier côté (6) du matériau de substrat (2) et/ou un deuxième côté (9) du matériau de substrat (2).

15. Composant micromécanique (1) selon l'une des revendications précédentes, **caractérisé en ce que** le composant micromécanique (1) est planarisé depuis le deuxième côté (9) du matériau de substrat (2) jusque dans un plan de la structure de tranchée (3).

16. Composant micromécanique (1) selon la revendication 11 ou 12, **caractérisé en ce que** la plaquette formant coiffe (17) comprend un composite formé d'une plaquette de Pyrex et d'une plaquette de silicium.

17. Composant micromécanique (1) selon la revendication 11 ou 12, **caractérisé en ce que** la plaquette formant coiffe (17) est constituée d'une plaquette de Pyrex.

18. Composant micromécanique (1) selon la revendication 11 ou 12, **caractérisé en ce que** la plaquette formant coiffe (17) est constituée d'une plaquette de silicium.
